# DEMANDE DE BREVET EUROPEEN

(11) **EP 1 494 287 A1**
(43) Date de publication de la demande: **05.01.2005**
(21) Numéro de dépôt: 04291637.9
(22) Date de dépôt: 29.06.2004
(51) Int. Cl.: H01L 27/06

(54) **Element DRAM comprenant deux cellules de stockage et son procéde de fabrication**

(30) Priorité: 01.07.2003 FR 0307960
(71) Demandeur: STMicroelectronics S.A., 92120 Montrouge (FR)
(72) Inventeur: Jacquet, François, 38190 Froges (FR); Candellier, Philippe, 38190 St. Mury Monteymond (FR); Cerutti, Robin, 38100 Grenoble (FR); Coronel, Philippe, 38530 Beauregard (FR); Mazoyer, Pascale, 38420 Domene (FR)
(74) Mandataire: Loisel, Bertrand

(57) **Abrégé**

Un élément intégré de mémoire dynamique à accès aléatoire comprend deux cellules (C0, C1) pour le stockage de deux bits respectifs, une zone de source (102) et une zone de drain (103). Chaque cellule comprend un transistor à effet de champ ayant une grille (4, 14) et une portion intermédiaire (1, 11). Chaque transistor comprend en outre une source (2, 12), un drain (3, 13) et un canal (1c, 11c) disposés respectivement dans la zone de source, la zone de drain et la portion intermédiaire (1, 11). L'élément comprend une électrode de polarisation (24) disposée entre les portions intermédiaires (1, 11) respectives des deux transistors, l'électrode de polarisation étant couplée de façon capacitive avec la portion intermédiaire de chaque transistor.

## Description

La présente invention concerne un élément intégré de mémoire dynamique à accès aléatoire, ou DRAM («Dynamic Random Access Memory»).

Un élément DRAM comprend, de façon connue, un transistor à effet de champ et un composant électronique dans lequel est stockée une quantité de charges électriques représentative d'un bit. Le composant de stockage de la quantité de charges peut être, par exemple, un condensateur. Le transistor permet de contrôler le chargement du condensateur avec une quantité de charges déterminée, lors d'une étape d'écriture du bit dans l'élément DRAM. Il permet aussi de contrôler une évacuation de la quantité de charges stockée dans le condensateur, lors d'une étape de lecture du bit.

Il est connu, en particulier du document US 2003/0015757, d'utiliser une portion du transistor de l'élément DRAM, située d'un côté du canal du transistor opposé à la grille, pour stocker la quantité de charges représentative du bit. Cette portion du transistor est désignée dans la suite par portion de stockage. Le fonctionnement en lecture ou écriture de l'élément DRAM est alors sensiblement le même que pour un élément DRAM à condensateur. Une électrode supplémentaire est prévue contre le transistor, qui est couplée de façon capacitive avec la portion de stockage. Lorsque cette électrode est polarisée, une quantité de charges électriques est générée ou non dans la portion de stockage du transistor lors de l'étape d'écriture, selon la valeur du bit. Cette quantité de charges reste dans la portion de stockage après une interruption de la polarisation de l'électrode. Lors de l'étape de lecture, une valeur de la tension de seuil du transistor est détectée, qui dépend de la présence ou non de charges dans la portion de stockage.

Les dispositifs informatiques actuellement requis pour exécuter des applications complexes nécessitent des quantités importantes d'éléments DRAM. Ces éléments DRAM sont réalisés sur des substrats semiconducteurs qui correspondent à une partie notable de leur prix de revient. Il existe par conséquent un enjeu économique important à pouvoir réaliser un grand nombre d'éléments DRAM sur une surface minimale de substrat.

Un but de la présente invention consiste à proposer un élément DRAM compact, en considération du nombre de bits qui peuvent être stockés.

L'invention concerne un élément intégré de mémoire dynamique à accès aléatoire comprenant des première et seconde cellules pour le stockage de deux bits respectifs. L'élément comprend aussi une zone de source et une zone de drain qui comportent des portions respectives de matériau semiconducteur d'un même type de conduction électrique. Chaque cellule comprend un transistor à effet de champ ayant une grille et une portion intermédiaire de matériau semiconducteur, et ayant en outre une source, un drain et un canal situés respectivement dans la zone de source, la zone de drain et la portion intermédiaire. Les deux transistors sont disposés en parallèle entre la zone de source et la zone de drain. L'élément comprend en outre une électrode de polarisation disposée entre les portions intermédiaires respectives des deux transistors. L'électrode de polarisation est isolée électriquement de chaque transistor et est couplée de façon capacitive avec la portion intermédiaire de chaque transistor.

L'élément DRAM de l'invention permet donc le stockage de deux bits indépendants, alors qu'il ne comprend qu'une électrode de polarisation unique. Un gain de compacité est donc obtenu par rapport à deux cellules DRAM à stockage de charges électriques dans le transistor, indépendantes entre elles. Ce gain résulte de la suppression d'une électrode de polarisation par paire de cellules.

Selon le mode de réalisation préféré de l'invention, la grille de chaque transistor de l'élément DRAM est disposée d'un côté opposé de la portion intermédiaire dudit transistor par rapport à l'électrode de polarisation. Cette configuration procure un couplage capacitif particulièrement efficace de l'électrode de polarisation avec la portion intermédiaire de chaque transistor. Le fonctionnement de l'élément DRAM lors de l'étape d'écriture est ainsi amélioré.

En outre, la portion intermédiaire de l'un des deux transistors, l'électrode de polarisation et la portion intermédiaire de l'autre transistor peuvent être alignées selon une direction de juxtaposition des deux transistors de l'élément DRAM. Il en résulte une configuration de l'élément encore plus compacte.

Lorsque l'élément DRAM est réalisé à la surface d'un substrat, la direction de juxtaposition peut être sensiblement perpendiculaire à la surface du substrat. L'élément DRAM ainsi orienté occupe une portion de la surface du substrat particulièrement petite.

L'invention concerne aussi un plan mémoire qui comprend des éléments DRAM du type précédent, disposés selon un agencement matriciel.

L'invention concerne enfin un procédé de fabrication d'éléments DRAM du type de l'invention. Un tel procédé comprend les étapes suivantes :
- formation, sur une surface d'un substrat, d'un empilement comprenant, à partir de ladite surface, une première portion d'un matériau temporaire, une première portion intermédiaire, une deuxième portion de matériau temporaire, une seconde portion intermédiaire et une troisième portion de matériau temporaire disposées entre une zone de source et une zone de drain portées par le substrat et constituées de matériau semiconducteur d'un même type de conduction électrique, les première et seconde portions intermédiaires étant en matériau semiconducteur et disposées en contact avec les zones de source et de drain ;
- retrait des première, deuxième et troisième portions de matériau temporaire de façon à former des évidements respectifs ;
- formation d'une grille inférieure, d'une électrode de polarisation et d'une grille supérieure dans les évidements respectifs des première, deuxième et troisième portions de matériau temporaire, la grille inférieure, l'électrode de polarisation et la grille supérieure étant chacune conductrice électriquement et isolée des zones de source et de drain, et isolée des première et secondes portions intermédiaires ; et
- réalisation de connexions électriques reliant respectivement la grille inférieure, l'électrode de polarisation et la grille supérieure.

D'autres particularités et avantages de la présente invention apparaîtront dans la description ci-après d'un exemple de réalisation non limitatif, en référence aux dessins annexés, dans lesquels :
- la figure 1 représente un élément DRAM selon l'invention ;
- les figures 2-4 sont des vues en perspective d'un circuit électronique intégré illustrant trois étapes d'un procédé de fabrication d'un élément DRAM selon la figure 1 ;
- la figure 5 représente une matrice d'éléments DRAM selon la figure 1.

Dans ces figures, pour raison de clarté, les dimensions des différentes parties de composants représentées ne sont pas en proportion avec leurs dimensions réelles. Ces figures sont des vues d'un substrat sensiblement plan portant un ou plusieurs éléments DRAM. D0 désigne une direction perpendiculaire à la surface du substrat, orientée vers le haut des figures. Dans la suite, les termes «sur», «sous», «inférieur» et «supérieur» sont utilisés en référence avec cette orientation. Par ailleurs, sur toutes les figures, des références identiques correspondent à des éléments identiques.

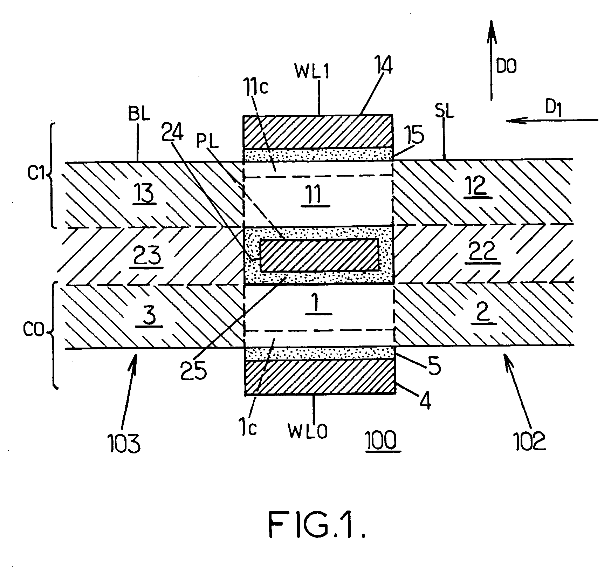

En référence à la figure 1, un élément DRAM selon l'invention comprend deux transistors MOS («Metal Oxide Semiconductor» ou transistor à effet de champ) superposés au dessus d'une surface d'un substrat 100, selon la direction D0. Le transistor inférieur comprend une source 2, une portion intermédiaire 1 et un drain 3 alignés selon une direction D1 parallèle à la surface du substrat. Il comprend en outre une grille 4 isolée de la portion 1 par une couche isolante 5. La grille 4 est reliée à une ligne de mot WL0 («Word Line» en anglais). Une partie inférieure de la portion 1, adjacente à la couche 5, constitue le canal 1 c du transistor inférieur. Le transistor inférieur constitue une cellule de stockage binaire C0.

Le transistor supérieur constitue une cellule de stockage binaire C1, et possède une structure symétrique de celle du transistor inférieur. Ainsi, une portion intermédiaire 11 est disposée entre une source 12 et un drain 13, en étant alignée avec ces derniers selon la direction D1. Une partie supérieure de la portion 11 constitue un canal 11c contrôlé par une grille 14, séparée de la portion 11 par une couche isolante 15. La grille 14 est reliée à une ligne de mot WL1 indépendante de la ligne WL0.

Les sources 2 et 12 des deux transistors sont en contact électrique avec une portion de source commune 22, disposée entre les sources 2 et 12. Elles constituent, avec la portion 22, une zone de source 102. La portion 22 peut présenter une concentration de dopage électrique inférieure aux concentrations de dopage des sources 2 et 12. La zone 102 est alimentée par une ligne de source SL («Source Line» en anglais). De même, les drains 3 et 13 des deux transistors sont en contact électrique avec une portion de drain commune 23, disposée entre les drains 3 et 13. Les drains 3 et 13 et la portion 23 constituent une zone de drain 103, qui est reliée à une ligne de drain BL («Bit Line» en anglais). La portion 23 peut présenter une concentration de dopage électrique inférieure à celles des drains 3 et 13.

Le potentiel électrique de la ligne de source SL est considéré dans la suite comme référence de potentiel électrique.

Une électrode de polarisation 24 est disposée entre, d'une part, les portions 1 et 11 selon la direction D0, et entre, d'autre part, les portions 22 et 23 selon la direction D1. L'électrode 24 est entourée d'une gaine de matériau isolant 25, qui la sépare des portions 1, 11, 22 et 23. Elle est par ailleurs reliée électriquement à une ligne de polarisation PL («Polarization Line» en anglais) indiquée en pointillés sur la figure 1.

L'écriture de deux valeurs de bits indépendantes dans les cellules C0 et C1 est effectuée en appliquant une tension positive, par exemple de 5 volts, entre la ligne de drain BL et la ligne de source SL. Simultanément, l'électrode 24 est portée à un potentiel électrique déterminé non nul, par exemple positif, transmis par la ligne de polarisation PL.

On applique alors un premier potentiel électrique, soit négatif ou nul, soit strictement positif, à la ligne de mot WL0, et un second potentiel électrique indépendant, de même soit négatif ou nul, soit strictement positif, à la ligne de potentiel WL1. Si le premier ou second potentiel électrique appliqué est positif, le transistor correspondant conduit alors un courant électrique suffisant pour provoquer une ionisation du matériau de la portion intermédiaire 1 ou 11 de ce transistor. Cette ionisation crée une charge électrique attirée par l'électrode de polarisation 24 du fait du couplage capacitif entre l'électrode 24 et les portions 1 et 11. Cette charge reste au sein de la portion 1 ou 11 dans laquelle elle a été créée si le circuit entre les lignes SL et BL est ouvert avant d'interrompre la polarisation de l'électrode 24. Si le premier ou second potentiel électrique appliqué est négatif ou nul, le transistor correspondant est bloqué, aucune ionisation n'est provoquée et aucune charge n'est créée dans la portion 1 ou 11 correspondante. Ainsi, en fonction des potentiels électriques transmis par les lignes WL0 et WL1, deux bits indépendants peuvent être enregistrés séparément dans les cellules C0 et C1, respectivement.

Les deux valeurs de bits ainsi enregistrées peuvent être lues séparément en appliquant une tension positive, par exemple de 5 volts, entre la ligne de drain BL et la ligne de source SL, et une tension de 2,5 volts par exemple à la ligne WL0 ou WL1 qui correspond au bit lu. Pour un potentiel électrique déterminé transmis par la ligne WL0 ou WL1, le courant électrique conduit par chaque transistor dépend de la charge électrique stockée dans le volume intermédiaire 1, 11 correspondant. La détection de ce courant permet la lecture de la valeur de bit enregistrée.

Un procédé de fabrication d'un circuit comprenant un élément DRAM tel que décrit ci-dessus est maintenant décrit. Les étapes élémentaires du procédé de fabrication d'un circuit électronique intégré connues de l'Homme du métier ne sont pas décrites. Une succession d'étapes élémentaires permettant de réaliser un tel élément DRAM est seulement indiquée.

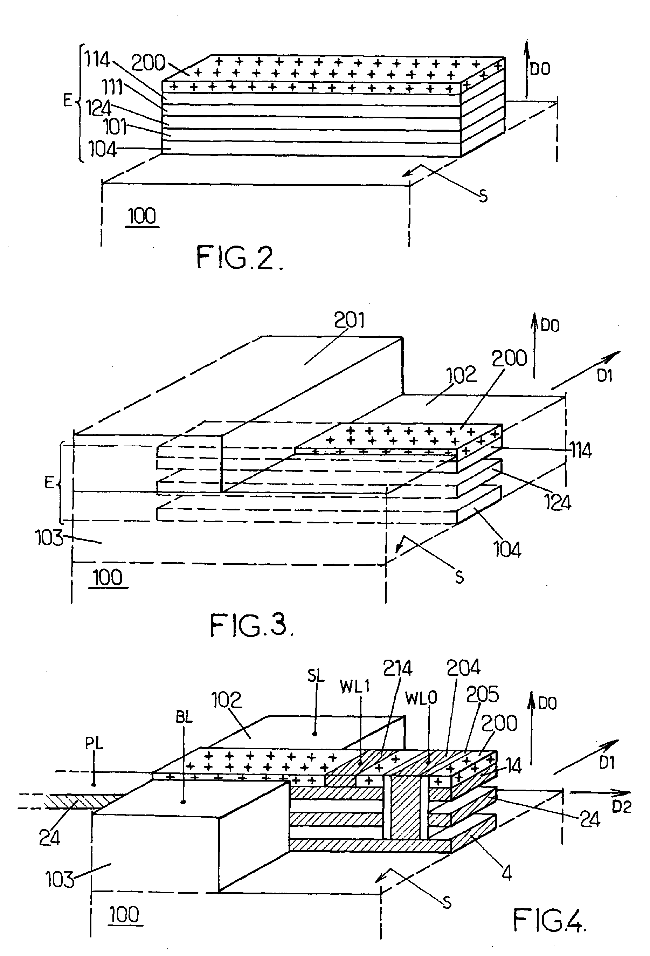

En référence avec la figure 2, un substrat 100, par exemple en silicium cristallin, présente une surface supérieure plane S. Le substrat 100 a été initialement traité en surface, afin d'être isolant électrique pour un contact par cette surface. Un tel traitement peut être, par exemple, une oxydation superficielle du substrat 100, de sorte que le substrat 100 reste cristallin jusqu'à sa surface S.

On forme alors successivement, sur le substrat 100, une première couche 104 d'un matériau temporaire, une première couche de silicium 101, une deuxième couche 124 de matériau temporaire, une seconde couche de silicium 111, une troisième couche de matériau temporaire 114, puis une couche d'un matériau de protection 200. Le matériau de protection peut être, par exemple, du nitrure de silicium. Le matériau temporaire est, par exemple, un alliage de silicium et de germanium. De façon connue, les couches 104, 101, 124, 111 et 114 peuvent être chacune obtenues par épitaxie, à partir de la surface S du substrat pour la couche 104, puis à partir de la surface supérieure de la dernière couche formée pour les couches suivantes.

On recouvre ensuite une partie médiane de la couche 200 avec un masque formé par lithographie (non représenté), puis on grave successivement les couches 200, 114, 111, 124, 101 et 104 en dehors du masque. On obtient alors la configuration du circuit représentée sur la figure 2, qui comprend un empilement E de portions superposées au dessus du substrat 100, selon la direction D0, correspondant respectivement aux couches 104, 101, 124, 111, 114 et 200.

On forme alors, sur la surface S, deux zones 102 et 103 de deux côtés opposés de l'empilement précédent, selon la direction D1. Les zones 102 et 103 sont formées jusqu'à une hauteur supérieure au niveau de la portion 200, selon la direction D0. Les zones 102 et 103 sont en silicium, et sont obtenues par épitaxie à partir de la surface S. Elles forment alors des reprises continues des portions 101 et 111 selon la direction D1.

La surface supérieure du circuit est alors polie selon la direction D0, en direction du substrat 100. Le matériau de la couche de protection 200 étant plus dur que le silicium des zones 102 et 103, les surfaces supérieures des zones 102 et 103 sont amenées à un niveau légèrement inférieur, selon la direction D0, à celui de la surface supérieure de la portion 200.

De façon connue, les portions 101 et 111, ainsi que les zones 102 et 103, peuvent être dopées par implantation pendant ou après leurs formations respectives sur le circuit. Un type de conduction électrique déterminé est ainsi obtenu pour chacune de ces portions ou zones. Par exemple, les portions 101 et 111 sont dopées pour obtenir des conductions de type p, et les zones 102 et 103 sont dopées pour obtenir des conductions de type n. De façon préférée, les concentrations de dopage des zones 102 et 103 sont variées selon la direction D0: elles sont plus importantes à des niveaux de ces zones correspondant aux hauteurs des portions 101 et 111 selon la direction D0.

On forme ensuite un masque épais 201, par exemple de silice, sur une partie du circuit (figure 3). Le masque 201 recouvre une partie de l'empilement E, ainsi que des parties des zones 102 et 103 adjacentes à la partie d'empilement recouverte.

Par gravure directionnelle, les parties respectives des zones 102 et 103 non recouvertes par le masque 201 sont éliminées. Des côtés latéraux des portions 104, 101, 124, 111 et 114 sont ainsi découverts dans la partie de l'empilement E non recouverte par le masque 201.

On implante alors du bore dans le circuit, jusqu'à un niveau inférieur à celui de la surface S, selon la direction D0. Grâce au masque épais 201, cette implantation est limitée à la partie du circuit non recouverte par le masque 201.

Par les côtés latéraux découverts des portions de l'empilement E, on retire sélectivement la première portion 104, la deuxième portion 124 et la troisième portion 114 de matériau temporaire, de façon à former des évidements respectifs. Ce retrait peut être opéré par gravure sèche isotrope et sélective de l'alliage de silicium et de germanium («selective isotropic dry etching»). Une telle étape de gravure élimine le matériau contenant du germanium sans altérer les matériaux des portions 101 et 111, ni les matériaux des parties résiduelles des zones 102 et 103, ni le matériau du substrat 100, qui sont dépourvus de germanium. Les portions 104, 124 et 114 sont intégralement retirées, y compris dans la partie de l'empilement E recouverte par le masque 201.

Le masque 201 est retiré.

On provoque alors une oxydation superficielle des surfaces des portions 101 et 111 et des zones 102 et 103 découvertes par les évidements. Une telle oxydation est réalisée, par exemple, en amenant un gaz oxydant au contact du circuit, et en chauffant le circuit de manière à contrôler l'épaisseur d'oxyde ainsi formée.

On dépose ensuite un matériau métallique dans les évidements formés en lieu et place des portions 104, 124 et 114. Le matériau métallique peut être, par exemple, du nitrure de titane (TiN), du nitrure de tantale (TaN), du tungstène (W) ou du cuivre (Cu), par exemple, et peut être obtenu par CVD («Chemical Vapour Deposition»). Des excès de matériau métallique déposés en dehors des évidements sont éliminés par gravure isotrope, soit par gravure sèche («dry etching»), soit par gravure humide («wet etching»). Ainsi une grille inférieure 4 est formée dans l'évidement correspondant à la portion 104, une électrode de polarisation 24 est formée dans l'évidement correspondant à la portion 124, et une grille supérieure 14 est formée dans l'évidement correspondant à la portion 114 (figure 4). Grâce à l'oxydation préalable des surfaces découvertes par les évidements, les grilles 4 et 14 et l'électrode 24 sont isolées électriquement des portions 101 et 111, ainsi que des zones 102 et 103, tout en étant couplées de façon capacitive avec les portions 101 et 111.

Des connexions électriques 204 et 214 reliant respectivement les grilles 4 et 14 sont ensuite réalisées, en combinant des procédés de masquage, de gravure directionnelle et de dépôt de matériau métallique. Une gaine isolante 205 peut éventuellement être disposée autour de la connexion 204, si la connexion 204 présente une configuration dans laquelle elle traverse la grille 14.

Enfin, le matériau de silicium implanté de bore appartenant aux portions 101 et 111 peut être sélectivement retiré par gravure humide, en utilisant un mélange d'acide fluorhydrique (HF), d'acide nitrique (HNO₃) et d'acide acétique (CH₃COOH). Un tel retrait permet de limiter les canaux des deux transistors aux parties des portions 101 et 111 situées entre les zones 102 et 103, dans la partie du circuit correspondant au masque 201. Un matériau de remplissage isolant électriquement peut être déposé à la place des parties des portions 101 et 111 ainsi retirées.

Dans le circuit ainsi réalisé, les zones 102 et 103 correspondent respectivement à la zone de source et à la zone de drain décrites en relation avec la figure 1. Dans la zone 102, la source 2, la portion de source 22 et la source 12 correspondent aux différents niveaux selon la direction D0 associés à des concentrations différentes de dopage électrique. De la même façon, les différents niveaux créés dans la zone 103 selon la direction D0 et associés à des concentrations différentes de dopage correspondent respectivement au drain 3, à la portion de drain 23 et au drain 13. La gaine isolante 25 de la figure 1 est formée lors de l'oxydation superficielle des surfaces des portions 101 et 111 et des zones 102 et 103 momentanément découvertes par la formation des évidements.

De façon connue, des connexions peuvent être réalisées sur les zones 102 et 103, respectivement par des lignes SL et BL. De même, les connexions 204 et 214 peuvent être prolongées par des lignes respectives WL0 et WL1. Par ailleurs, l'électrode 24 peut être allongée à une extrémité de l'empilement E opposée aux connexions 204 et 214, pour permettre la réalisation d'une connexion avec une ligne PL.

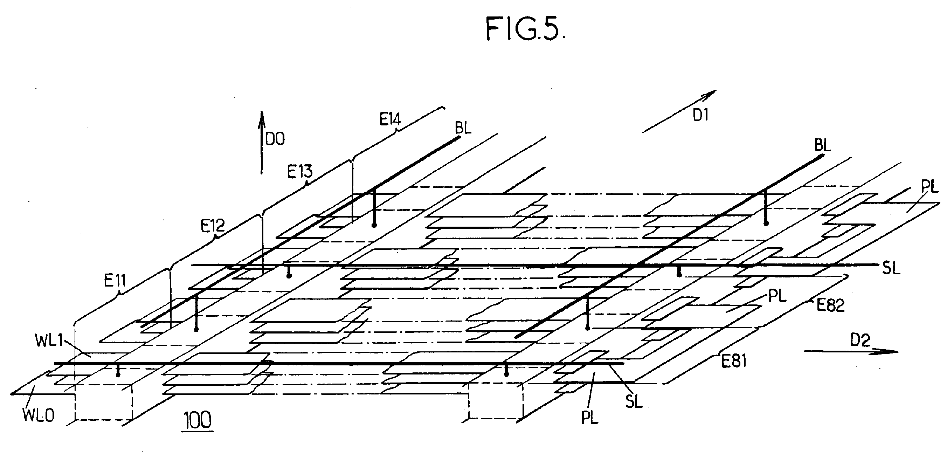

La figure 5 représente un plan mémoire constitués d'éléments DRAM tels que décrits en relation avec les figures 1 à 4. Dans ce plan mémoire, les éléments DRAM sont disposés de façon particulièrement compacte pour accroître la capacité de stockage binaire par unité de surface du substrat. Ils sont en outre connectés électriquement de façon à permettre l'enregistrement de séquences binaires. De telles séquences peuvent être des octets correspondant à des adresses de stockage distinctes.

Les éléments DRAM sont disposés selon un agencement matriciel à la surface d'un substrat 100. La direction D0 d'alignement de l'électrode de polarisation 24 et des portions intermédiaires 1 et 11 des deux transistors de chaque élément est perpendiculaire à la surface du substrat 100.

L'agencement matriciel comporte des rangées et des colonnes d'éléments DRAM. Les rangées sont parallèles à la direction D2 et les colonnes sont parallèles à la direction D1. Sur la figure 5, les éléments DRAM E11,..., E81 forment la première rangée, et les éléments E11, E12,... forment la première colonne.

Chaque rangée possède une première région conductrice dans laquelle sont formées les grilles 4 des transistors des premières cellules C0 des éléments DRAM de la rangée. Cette première région conductrice peut être formée de prolongements continus des grilles 4 entre deux éléments voisins d'une même rangée. Elle est reliée à une ligne de mot inférieure WL0.

Chaque rangée possède aussi une seconde région conductrice dans laquelle sont formées les grilles 14 des transistors des secondes cellules C1 des éléments DRAM de la rangée. De même que pour la première région conductrice, la seconde région conductrice peut être formée de prolongements continus des grilles 14 entre deux éléments voisins d'une même rangée. Elle est reliée à une ligne de mot supérieure WL1.

Chaque rangée possède en outre une troisième région conductrice dans laquelle sont formées les électrodes de polarisation 24 dés éléments DRAM de la rangée. Cette troisième région conductrice peut aussi être formée de prolongements continus des électrodes 24 entre deux éléments voisins d'une même rangée. Elle est et reliée à une ligne de polarisation (PL).

Chaque colonne a une région dopée où sont formées les zones de source 102 et de drain 103 et les portions intermédiaires 1, 11 des cellules C0 et C1 des éléments DRAM de la colonne. Les portions intermédiaires 1, 11 des cellules de deux éléments adjacents de la colonne sont séparés par une zone de source 102 ou de drain 103 commune aux dits deux éléments.

Les éléments DRAM du plan mémoire sont en outre connectés de la façon suivante : les zones de source 102 des éléments de chaque rangée sont reliées à une ligne de source SL s'étendant parallèlement à la rangée, et les zones de drain 103 des éléments de chaque colonne sont reliées à une ligne de bit BL s'étendant parallèlement à la colonne.

Selon un perfectionnement du mode de connexion des éléments DRAM, les troisièmes régions conductrices de deux rangées adjacentes d'éléments DRAM ayant des zones de drain 103 communes sont reliées entre elles.

Une rangée d'éléments DRAM peut comporter, par exemple, 1024 éléments, avec autant de lignes de bit BL associées, afin de permettre le stockage de deux ensembles de 1024 bits respectivement dans les cellules C0 et C1 des éléments de cette rangée. Un multiplexeur de lignes BL permet de sélectionner, de façon connue, huit éléments DRAM de cette rangée. Deux octets stockés respectivement dans les cellules C0 et C1 des huit éléments sélectionnés sont ainsi obtenus. Les adressages de ces deux octets sont différenciés par les lignes WL0 et WL1 correspondantes.

Le plan mémoire ainsi obtenu peut être augmenté par des opérations de symétrie ou de répétition d'ensembles d'éléments DRAM agencés de la façon décrite ci-dessus, opérées selon les directions D1 et ou D2. Une capacité de stockage multipliée est alors obtenue.

Les étapes de lithographie effectuées au cours du procédé de fabrication décrit plus haut imposent une limite inférieure pour toutes les dimensions parallèles à la surface S du substrat 100. Une dimension minimale F est ainsi fixée par le procédé de lithographie utilisé. Les côtés des zones 102 et 103 parallèles aux directions D1 et D2 peuvent posséder cette dimension minimale, de même que la largeur, selon la direction D1, de l'empilement E mis en oeuvre pour chaque élément. La largeur de l'empilement E parallèlement à la direction D1 correspond à la longueur des canaux 1c et 11c des transistors de chaque élément. En outre, chaque élément DRAM d'une colonne déterminée est séparé par une colonne isolante, qui peut être du type STI (pour «Shallow Trench Isolation»), d'un élément DRAM d'une colonne voisine. Cette colonne isolante peut aussi avoir une largeur égale à la dimension minimale F. Il apparaît alors que le motif du plan mémoire associé à un élément DRAM correspond à une surface projetée sur la surface du substrat égale à la somme d'une surface projetée de zone 102 ou 103 égale à F², d'une surface projetée d'empilement E aussi égale à F², et d'une surface projetée associée à un élément de longueur de colonne isolante égale à 2xF². On obtient ainsi une surface projetée totale de 4xF² par élément DRAM, soit de 2xF² par bit stocké. Cette densité de stockage par unité de surface du substrat constitue l'un des avantages de la présente invention.

## Revendications

1. Elément intégré de mémoire dynamique à accès aléatoire comprenant des première (C0) et seconde (C1 ) cellules pour le stockage de deux bits respectifs, une zone de source (102) et une zone de, drain (103) comportant des portions respectives de matériau semiconducteur d'un même type de conduction électrique,
chaque cellule comprenant un transistor à effet de champ ayant une grille (4, 14) et une portion intermédiaire (1, 11) de matériau semiconducteur, et ayant en outre une source (2, 12), un drain (3, 13) et un canal (1c, 11c) situés respectivement dans la zone de source (102), la zone de drain (103) et la portion intermédiaire (1,11),
les deux transistors étant disposés en parallèle entre la zone de source (102) et la zone de drain (103),
l'élément comprenant en outre une électrode de polarisation (24) disposée entre les portions intermédiaires (1, 11) respectives des deux transistors, isolée électriquement de chaque transistor et couplée de façon capacitive avec la portion intermédiaire de chaque transistor.

2. Elément selon la revendication 1, dans lequel la grille (4, 14) de chaque transistor est disposée d'un côté opposé de la portion intermédiaire (1, 11) dudit transistor par rapport à l'électrode de polarisation (24).

3. Elément selon la revendication 2, dans lequel la portion intermédiaire (1) de l'un des deux transistors, l'électrode de polarisation (24) et la portion intermédiaire (11) de l'autre transistor sont alignées selon une direction de juxtaposition (D0) des deux transistors dudit élément.

4. Elément selon la revendication 3, dans lequel la direction de juxtaposition (D0) est sensiblement perpendiculaire à une surface (S) d'un substrat (100) portant ledit élément.

5. Plan mémoire comprenant des éléments de mémoire dynamique à accès aléatoire selon l'une quelconque des revendications précédentes, disposés selon un agencement matriciel.

6. Plan mémoire selon la revendication 5 disposé à la surface (S) d'un substrat (100), dans lequel l'électrode de polarisation (24) de chaque élément (E11,..., E82 ,...) est disposée entre les portions intermédiaires respectives (1, 11) des deux transistors dudit élément, selon une direction (D0) perpendiculaire à la surface du substrat (S).

7. Plan mémoire selon la revendication 6, dans lequel l'agencement matriciel comporte des rangées d'éléments de mémoire dynamique à accès aléatoire (E11,..., E81,...), chaque rangée ayant une première région conductrice dans laquelle sont formées les grilles des transistors des premières cellules (4) des éléments de la rangée et reliée à une ligne de mot inférieure (WL0), une seconde région conductrice dans laquelle sont formées les grilles des transistors des secondes cellules (14) des éléments de la rangée et reliée à une ligne de mot supérieure (WL1), et une troisième région conductrice dans laquelle sont formées les électrodes de polarisation (24) des éléments de la rangée et reliée à une ligne de polarisation (PL).

8. Plan mémoire selon la revendication 7, dans lequel l'agencement matriciel comporte aussi des colonnes d'éléments de mémoire dynamique à accès aléatoire (E11, E12,...), chaque colonne ayant une région dopée où sont formées les zones de source (102) et de drain (103) et les portions intermédiaires des cellules (1, 11) des éléments de la colonne, les portions intermédiaires des cellules de deux éléments adjacents de la colonne étant séparés par une zone de source (102) ou de drain (103) commune aux dits deux éléments, les zones de drain (103) des éléments de la colonne (E11, E12,...) étant reliées à une ligne de bit (BL) s'étendant parallèlement à la colonne, les zones de source (102) des éléments de chaque rangée (E11,..., E81,...) étant reliées à une ligne de source (SL) s'étendant parallèlement à la rangée.

9. Plan mémoire selon la revendication 7 ou 8, dans lequel les troisièmes régions conductrices de deux rangées adjacentes d'éléments ayant des zones de drain (103) communes sont reliées entre elles.

10. Procédé de fabrication d'un d'élément intégré de mémoire dynamique à accès aléatoire sur une surface (S) d'un substrat (100), comprenant les étapes suivantes :
- formation, sur ladite surface (S), d'un empilement comprenant, à partir de ladite surface, une première portion d'un matériau temporaire (104), une première portion intermédiaire (101), une deuxième portion de matériau temporaire (124), une seconde portion intermédiaire (111) et une troisième portion de matériau temporaire (114) disposées entre une zone de source (102) et une zone de drain (103) portées par le substrat (100) et constituées de matériau semiconducteur d'un même type de conduction électrique, les première (101) et seconde (111) portions intermédiaires étant en matériau semiconducteur et disposées en contact avec les zones de source (102) et de drain (103) ;
- retrait des première (104), deuxième (124) et troisième (114) portions de matériau temporaire de façon à former des évidements respectifs ;
- formation d'une grille inférieure (4), d'une électrode de polarisation (24) et d'une grille supérieure (14) dans les évidements respectifs des première (104), deuxième (124) et troisième (114) portions de matériau temporaire, la grille inférieure, l'électrode de polarisation et la grille supérieure étant chacune conductrice électriquement et isolée des zones de source (102) et de drain (103), et isolée des première (101) et secondes (111) portions intermédiaires ; et
- réalisation de connexions électriques reliant respectivement la grille inférieure (4), l'électrode de polarisation (24) et la grille supérieure (14).

11. Procédé selon la revendication 10, dans lequel le substrat (100) est monocristallin, et dans lequel l'empilement comprenant la première portion de matériau temporaire (104), la première portion intermédiaire (101), la deuxième portion de matériau temporaire (124), la seconde portion intermédiaire (111) et la troisième portion de matériau temporaire (114) est formé par épitaxie à partir de la surface du substrat (S).

12. Procédé selon la revendication 11, dans lequel les zones de source (102) et de drain (103) sont formées par épitaxie à partir de la surface du substrat (S).

13. Procédé selon l'une quelconque des revendications 10 à 12, dans lequel la grille inférieure (4), l'électrode de polarisation (24) et la grille supérieure (14) sont chacune constituées de matériau métallique.
